# EUROPEAN PATENT APPLICATION

(11) **EP 4 207 520 A1**
(43) Date of publication of application: **05.07.2023**
(21) Application number: 20951228.4
(22) Date of filing: 09.12.2020
(51) Int. Cl.: H01S 5/40

(54) **SEMICONDUCTOR LASER DEVICE**

(30) Priority: 28.08.2020 CN 202010888281
(71) Applicant: Nanjing Fiber Foton Technologies Corporation Limited, Nanjing, Jiangsu 211899 (CN)
(72) Inventor: HE, Xiaoguang, Nanjing, Jiangsu 210000 (CN); HAO, Liang, Nanjing, Jiangsu 210000 (CN); LIU, Rui, Nanjing, Jiangsu 210000 (CN)
(74) Representative: Haseltine Lake Kempner LLP
(86) International application number: PCT/CN2020/134776
(87) International publication number: WO 2022/041561

(57) **Abstract**

A semiconductor laser device is provided, comprising: at least two laser light-emitting units (101-1, 101-2); a group of beam shaping components (102, 103), the at least two laser light-emitting units (101-1, 101-2) multiplexing the group of beam shaping components (102, 103) to shape the laser beam emitted by each unit; a fiber optic coupler (104-1, 104-2); and at least two optical fibers (105-1, 105-2), wherein the number of the optical fibers is equal to that of the laser light-emitting units. The laser beams (101-11, 101-12) respectively emitted by the laser light-emitting units are shaped by the group of beam shaping components and then respectively coupled into the optical fibers by the fiber optic coupler, resulting in a reduction in the overall weight and volume of the device. This reduction leads to a decrease in device costs and man-hour costs for producing the device, and an improvement in the packaging reliability.

## Description

### CROSS-REFERENCE TO RELATED APPLICATION(S)

This application claims the priority to the Chinese Patent Application No.202010888281.4, filed on August 28, 2020, which is herein incorporated by reference in its entirety.

### FIELD OF THE INVENTION

The invention relates to the technical field of lasers, in particular to a semiconductor laser device.

### BACKGROUND OF THE INVENTION

High-power semiconductor laser devices are essential components in the field of laser processing technology, and their packaging and preparation are crucial. The quality of packaging directly affects the spectral and optoelectronic parameters, reliability, and lifespan of the laser. Additionally, as packaging technology advances, there are increasingly stringent requirements for miniaturization of package volume and weight, production efficiency, and yield.

In prior arts, semiconductor laser devices with spatial beam combination mainly use a fast axis collimator lens (FAC), a slow axis collimator lens (SAC), a reflector, and a fiber optic coupler (FOC) to shape and couple the light beam emitted by a single semiconductor laser light-emitting unit. The beam then enters the optical fiber to achieve the entire coupling process. To achieve higher power output, multiple semiconductor laser light-emitting units are stacked in steps in the fast axis direction, and each semiconductor laser light-emitting unit corresponds to its own FAC, SAC, and reflector. Finally, the beams are combined and enter the same optical fiber through the FOC.

In this packaging form, each semiconductor laser light-emitting unit is coupled to the optical fiber through its own corresponding optical device link, resulting in a large number of repeated optical elements in the entire structure. The semiconductor laser light-emitting units fail to share the optical elements with each other, making it difficult to reduce device and labor costs. Additionally, due to the large number of elements, it is challenging to control the reliability, volume, and weight of the package, which does not meet downstream application requirements for semiconductor laser packaging.

### SUMMARY OF THE INVENTION

In light of the issues with conventional semiconductor laser devices, the objective of the present invention is to provide a high-power spatial beam combining semiconductor laser device capable of multiplexing optical paths.

Embodiments of the present invention describe a semiconductor laser device comprising at least two laser light-emitting units, a group of beam shaping components, a fiber optic coupler, and at least two optical fibers. The at least two laser light-emitting units multiplex the group of beam shaping components to shape the laser beam emitted by each unit. The laser beams emitted by the at least two laser light-emitting units are respectively coupled into the at least two optical fibers through the fiber optic coupler after being shaped by the group of beam shaping components. The number of the optical fibers is equal to that of the laser light-emitting units.

In some embodiments of the present invention, the laser beams emitted by the at least two laser emitting units have the same propagation direction and the same divergence angle. In some embodiments, the at least two laser light-emitting units are produced by cutting a semiconductor laser Bar.

In some embodiments of the present invention, the group of beam shaping components comprises a fast axis collimator lens and a slow axis collimator lens.

In some embodiments of the present invention, the at least two laser light-emitting units and the group of beam shaping components that are multiplexed by them are used as a module, and the module further comprises a reflector for changing the direction of the laser beams that have been shaped by the group of beam shaping components. The semiconductor laser device comprises a plurality of said modules.

In some embodiments of the present invention, the plurality of modules is configured such that optical paths from the laser light-emitting units of each module to the optical fibers are equal.

In some embodiments of the present invention, the spacing between adjacent modules in the plurality of modules in the horizontal direction is the same, and larger than a first value that represents the length of the major axis of the elliptical cross-sectional shape of the laser beam from the reflector.

In some embodiments of the present invention, the plurality of modules is arranged in steps in the fast axis direction, with the step height between adjacent modules being the same and larger than a second value that represents the length of the minor axis of the elliptical cross-sectional shape of the laser beam from the reflector.

In some embodiments of the present invention, the plurality of modules is configured such that the propagation direction of the laser beams emitted from the laser light-emitting units in a first portion of the plurality of modules intersects the propagation direction of the laser beams emitted from the laser light-emitting units in a second portion of the plurality of modules, and the second portion of the plurality of modules multiplexes the reflector of one module of the first portion.

In some embodiments of the present invention, the at least two laser light-emitting units and the group of beam shaping components multiplexed by them are used as a module. The semiconductor laser device includes a plurality of said modules arranged in parallel in a fast axis direction. The group of beam shaping components comprises a fast axis collimator lens. The semiconductor laser device further comprises a slow axis collimator lens arranged between the plurality of modules and the fiber optic coupler, such that the plurality of modules can multiplex the slow axis collimator lens.

In some embodiments of the present invention, the semiconductor laser device further comprises a corrector provided between the fiber optic coupler and the optical fibers for correcting each laser beam after it enters the optical fiber. For example, the corrector can be a split prism or a concave lens, or the end face of the optical fiber is configured as an inclined end face to function as the corrector.

In an alternative embodiment of the present invention, the fiber optic coupler comprises a slow axis focusing cylindrical lens and a fast axis focusing cylindrical lens. In some embodiments of the present invention, the slow axis collimator lens and the slow axis focusing cylindrical lens form a double telecentric optical path to correct the angle of each laser beam after it enters the optical fiber.

In some embodiments of the present invention, the at least two optical fibers are fixed in a close-packed structure or a ceramic ferrule.

In some embodiments of the present invention, the semiconductor laser device further comprises a spectral beam combiner and/or a polarization beam combiner between the fiber optic coupler and the group of beam shaping components. For example, the spectral beam combiner or the polarization beam combiner is disposed between the reflector and the fiber coupler. Optionally, the spectral beam combiner and the polarization beam combiner are sequentially arranged between the reflector and the fiber optic coupler. Specifically, the laser beams reflected by the reflector firstly pass through the spectral beam combiner to superpose the laser beams with different wavelengths, and then pass through the polarization beam combiner to superpose the *p* light and the s light.

In comparison to prior arts, the embodiments of the present invention offer the following beneficial technical effects:

The device of the embodiments of the present invention utilizes at least two semiconductor laser light-emitting units that can be coupled to a plurality of optical fibers, thereby achieving output of a plurality of tail fibers.

Compared to existing packaging forms, the device of the present invention can multiplex most optical elements, resulting in a reduction of the overall weight and volume of the semiconductor laser device. This leads to decreased device and man-hour costs, improved packaging reliability, and increased output power by several times under the same volume and number of elements as in existing devices.

By incorporating a corrector, the device of the present invention can solve the problem of the combined beam's optical axis not being parallel to that of the beam in the corresponding optical fiber before it enters the fiber. This results in improved energy concentration of the output beam from the optical fiber and reduced probability of the beam overflowing the core of the fiber.

### BRIEF DESCRIPTION OF THE DRAWINGS

Fig. 1A is a schematic structural view of a semiconductor laser device according to an embodiment of the present invention. Fig. 1B is a schematic diagram of a double telecentric optical path of the semiconductor laser device shown in Fig. 1A.
Fig. 2A is a schematic structural view of a semiconductor laser device according to another embodiment of the present invention in the horizontal direction. Fig. 2B is a schematic structural view of the semiconductor laser device shown in Fig. 2A in the vertical direction.
Figs. 3A and 3B are respectively enlarged views of regions A and B in Fig. 2A.
Fig. 4A is a schematic diagram illustrating a spot pattern of laser beams emitted from a single module of the semiconductor laser device shown in Fig. 2A. Fig. 4B is a schematic diagram illustrating a spot pattern of laser beams emitted from all modules in the semiconductor laser device shown in Fig. 2A.
Fig. 5A is an enlarged view of a portion of the optical fibers of a semiconductor laser device according to another embodiment of the present invention. Fig. 5B is an enlarged view of a portion of the optical fibers of a semiconductor laser device according to yet another embodiment of the present invention.
Fig. 6A is a schematic structural view of a semiconductor laser device according to yet another embodiment of the present invention. Fig. 6B is a three-dimensional structural view of the semiconductor laser device shown in Fig. 6A.
Fig. 7 is a schematic structural view of a semiconductor laser device according to yet another embodiment of the present invention.
Fig. 8 is a schematic structural view of a semiconductor laser device according to yet another embodiment of the present invention.

### DETAI'LED DESCRIPTION OF THE INVENTION

Various aspects of the present invention will be described in detail below, with reference to the drawings and specific embodiments. It should be noted that the structures shown in the drawings are not drawn completely to scale and are provided for the purpose of illustrating the concept of the present invention.

It should be understood by those skilled in the art that the various embodiments are described below for purpose of illustration only and are not intended to limit the scope of the invention. It should also be understood that the structures in the various embodiments of the invention described herein and illustrated in the drawings can have many variations.

### [Example 1]

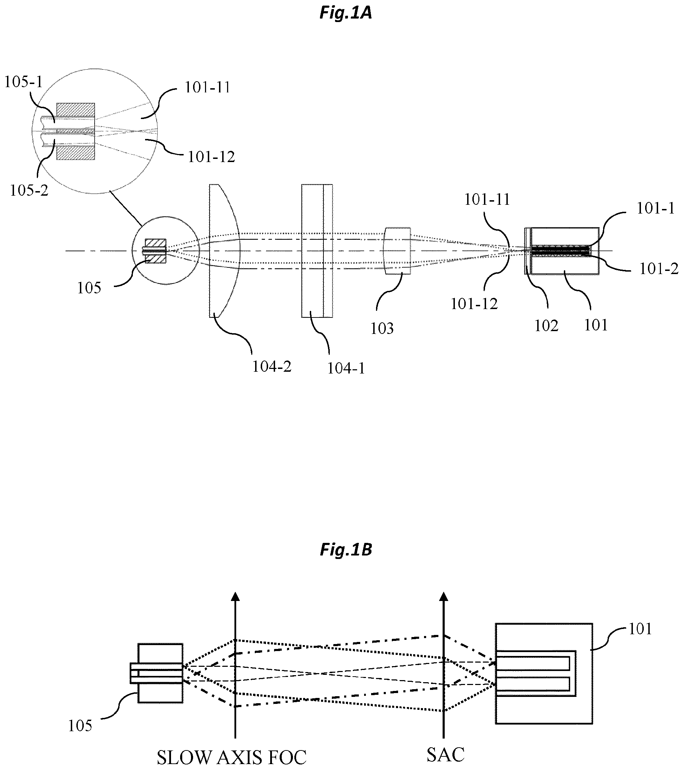

Example 1 provides a semiconductor laser device, as shown in Fig. 1A, which is a schematic structural view of a semiconductor laser device according to an embodiment of the present invention.

The semiconductor laser device in this example comprises two laser light-emitting units 101-1 and 101-2, a group of beam shaping components including a fast axis collimator lens (FAC) 102 and a slow axis collimator lens (SAC) 103. The two laser light-emitting units multiplex the group of beam shaping components to shape the laser beams respectively emitted by the two laser light-emitting units. The device also includes a fiber optic coupler (FOC) with a fast axis focusing cylindrical lens 104-1 and a slow axis focusing cylindrical lens 104-2, and a close-packed structure 105 including two optical fibers 105-1 and 105-2. The laser beams emitted by the two laser light-emitting units 101-1 and 101-2 are shaped by the FAC 102 and the SAC 103, and then respectively coupled into the two optical fibers through the FOC lenses 104-1 and 104-2.

The two laser light-emitting units can be produced by cutting a semiconductor laser bar, inheriting all its structural properties such as bar width, duty cycle, width of each laser light-emitting unit, and spacing between the units. The laser light-emitting units 101-1 and 101-2 emit independent laser beams 101-11 and 101-12, respectively. These laser beams have the same properties such as the same propagation direction and divergence angle except for the different spatial positions of their emitting units.

In alternative embodiments, the semiconductor laser device is not limited to two laser light-emitting units and can include three, four, five, or more units depending on the number of optical fibers. Depending on the number of pigtails, i.e., optical fibers, the number of laser light-emitting units can be determined.

In other embodiments, the FOC can be a single lens or any other type of lens that can focus the laser beams.

Furthermore, in alternative embodiments, the optical fibers can also be secured using a ceramic ferrule or any other suitable means.

Additionally, in some embodiments of the present invention, a reflector can be included in the semiconductor laser device. The reflector can be positioned after the beam shaping components (FAC and SAC) and before the FOC, or it can be placed between the FAC and SAC. In this way, the same reflector can be used for both laser emitting units, and the shaped laser beams can be folded to the FOC by the reflector and then coupled into the two optical fibers through the FOC.

In some embodiments of the present invention, the SAC 103 and the slow axis focusing cylindrical lens 104-2 may form a double telecentric optical path to correct the angle of the laser beams after they enter the optical fibers. Fig. 1B illustrates the double-telecentric optical path. For clarity, other optical elements are not shown in Fig. 1B. As depicted in Fig. 1B, the slow axis collimator lens (SAC) and the slow axis FOC (i.e., the slow axis focusing cylindrical lens) form the double-telecentric optical path to correct the angle of the laser beams after they enter the fibers.

### [Example 2]

Example 2 provides a semiconductor laser device that differs from Example 1 in that it comprises a plurality of modules, where each module includes at least two semiconductor laser light-emitting units and a group of beam shaping components multiplexed by the at least two semiconductor laser light-emitting units, resulting in increased output power.

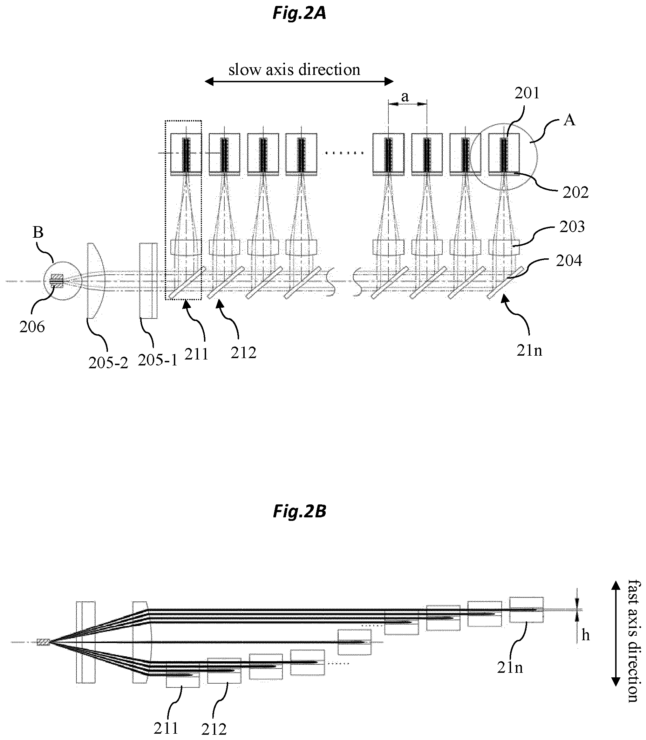

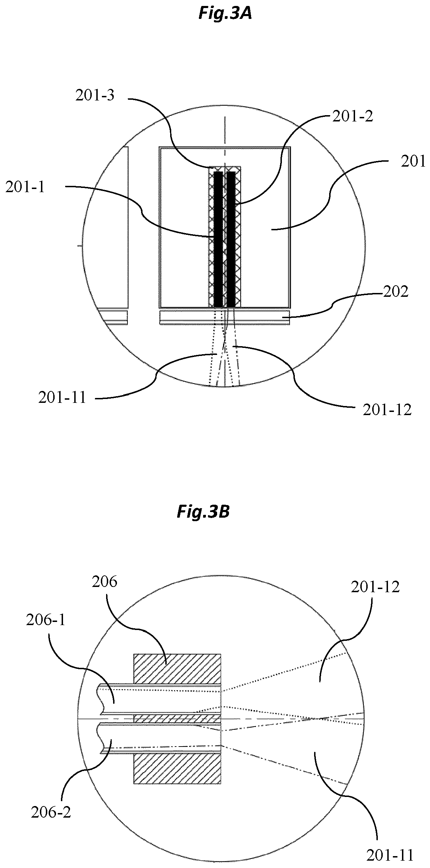

This will be described in detail with reference to Figs. 2A to 3B. Figs. 2A and 2B depict schematic structural views of another embodiment of the semiconductor laser device, while Figs. 3A and 3B depict enlarged views of regions A and B in Fig. 2A, respectively.

As shown in Figs. 2A to 3B, the semiconductor laser device in this embodiment comprises a plurality of modules 211, 212, ...21n, a FOC including a fast axis focusing cylindrical lens 205-1 and a slow axis focusing cylindrical lens 205-2, and a close-packed structure 206 which includes two optical fibers 206-1 and 206-2.

The plurality of modules 211, 212, ...21n are arranged in a step-like fashion in the vertical direction (fast axis direction). Each module comprises a semiconductor laser chip array (COS) 201, a group of beam shaping components including a fast axis cylindrical lens (FAC) 202 and a slow axis cylindrical lens (SAC) 203, as well as a reflector 204. The COS 201 comprises a chip 201-3 and two laser light-emitting units 201-1 and 201-2 mounted on it. The group of FAC 202 and SAC 203 is shared by the two laser light-emitting units 201-1 and 201-2. This means that the laser beams emitted from both units respectively pass through the FAC 202 and SAC 203 in the slow axis direction, get shaped by the FAC 202 and SAC 203, and are then folded toward the fast axis focusing cylindrical lens (FOC) 205-1 and slow axis focusing cylindrical lens (FOC) 205-2 by the same reflector 204 that is shared by two laser light-emitting units 201-1 and 201-2. Finally, the beams are coupled into the two optical fibers 206-1 and 206-2 by FOC 205-1 and 205-2, respectively. By arranging multiple modules in steps in the vertical direction (fast axis direction), the laser beams of each module are folded toward the same FOC 205-1 and 205-2 by the corresponding reflector to be coupled into the two optical fibers 206-1 and 206-2, respectively. As a result, the laser beams from n modules are coupled into the two optical fibers 206-1 and 206-2, respectively, thus multiplying the output power.

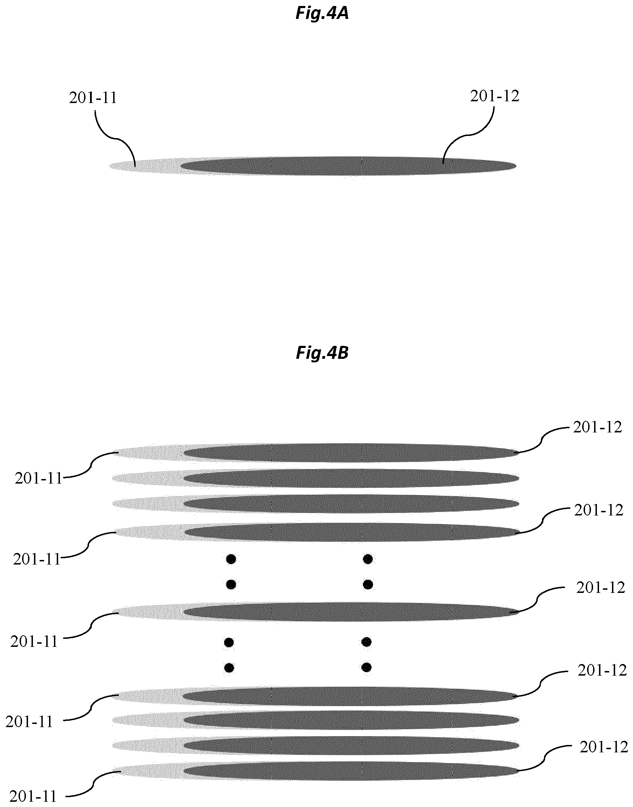

Due to the special properties of the semiconductor laser beam, the semiconductor laser beam has different divergence angles in the direction parallel to the PN junction compared to the direction perpendicular to it, and the fast axis divergence angle is much larger than the slow axis divergence angle. Therefore, the beam shaping of the semiconductor laser device requires two steps, one for the fast axis divergence angle and the other for the slow axis divergence angle. In this example, for one module, the laser beams 201-11 and 201-12 from the two laser light-emitting units 201-1 and 201-2 pass through the FAC 202 for collimation in the fast axis direction, then through the SAC 203 for collimation in the slow axis direction, and then are redirected by the reflector 204. At this point, the cross-sectional shape of the beam leaving the reflector is an ellipse, with the slow axis direction corresponding to the major axis and the length of the major axis being *a*, and the fast axis direction corresponding to the minor axis and the length of the minor axis being h. For the plurality of modules, the spacing between adjacent modules in the horizontal direction (slow axis direction) is the same and greater than *a*, and the modules are arranged in steps in the vertical direction (fast axis direction), with the step height between adjacent modules in the fast axis direction being the same and greater than h. As a result, the spot patterns of the beams emitted by all the modules, i.e., the beams after leaving the reflector 204 and before reaching the FOC 205-1 and 205-2, are in a closely stacked array in the fast axis direction, as shown in Fig. 4B. Afterward, all of the beams in Fig. 4B are focused into converging beams 201-11 and 201-12 through the FOC 205-1 and 205-2 (i.e., coupling lens group), respectively, and then coupled into the optical fibers 206-1 and 206-2, respectively.

At this point, the entire coupling process is completed, from the laser light-emitting units 201-1 and 201-2 emitting laser beams to the laser beams being shaped, focused, stacked through a series of optical elements, and finally entering the optical fibers 206-1 and 206-2.

In other embodiments of the present invention, the COS is not limited to including only 2 laser light-emitting units. The COS may also include 3, 4, 5 or more laser light-emitting units. In this case, the number of corresponding output fibers is the same as the number of laser light-emitting units.

In certain embodiments of the present invention, the two laser light-emitting units in each module can be obtained by cutting a semiconductor laser bar, allowing them to inherit all of the bar's structural properties such as bar width, duty cycle, width of each laser light-emitting unit, and spacing between the laser light-emitting units. The two laser light-emitting units 201-1 and 201-2 respectively emit the laser beams 201-11 and 201-12 which propagate independently. The two laser beams have the same properties such as the same propagation direction and divergence angle except for the different spatial positions of their emitting units. During spatial propagation, the two laser beams partially overlap with each other, as shown in Fig. 4A.

In other embodiments of the present invention, the FOC can be a single lens or any other lens that can function as a focusing lens.

In some embodiments of the present invention, the plurality of modules can be configured such that the optical paths from the laser light-emitting units of each module to the optical fibers are of equal length.

In some embodiments of the present invention, the plurality of modules can be arranged without steps in the fast axis direction. In such cases, the beams can be stepped in the fast axis direction using reflectors with a specific inclination angle, or other methods may be used to fold the laser beams of each module toward the FOC 205-1 and 205-2 for coupling into two optical fibers, so that the laser beams from the n modules can be respectively coupled into the two optical fibers.

### [Example 3]

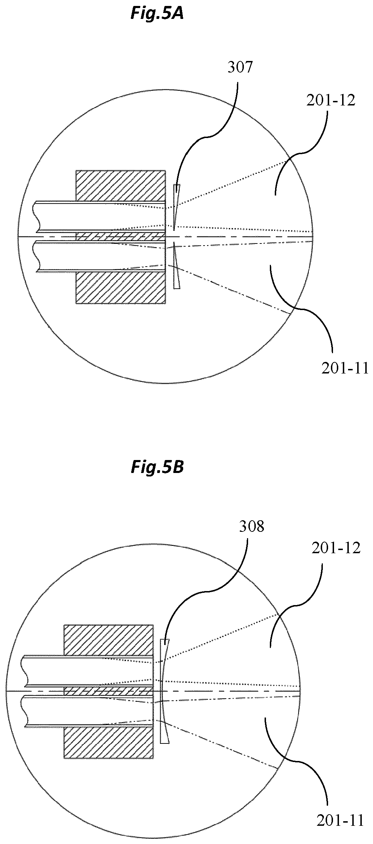

Example 3 provides a semiconductor laser device that differs from Example 2 in that it includes a corrector for correcting the angle of the laser beams after they enter the optical fibers. As shown in Fig. 5A, the corrector is a split prism 307, which redirects the laser beam to be incident into the optical fiber with its optical axis parallel to the optical axis of the optical fiber. This solves the problem of the optical axis of the converged beam of the laser beams 201-11 and 201-12 not being parallel to the corresponding optical fiber beam before entering the optical fiber. Consequently, the energy concentration of the output beam of the optical fiber can be improved, and the probability of the beam overflowing the core of the optical fiber can be reduced.

In some embodiments of the present invention, the corrector is a concave lens 308 as shown in Fig. 5B.

In an alternative embodiment, the end face of the optical fiber can be configured as an inclined end face to function as the corrector.

Alternatively or in addition, in certain embodiments of the present invention, the slow axis collimator lens (SAC) 203 and the slow axis focusing cylindrical lens 205-2 form a double-telecentric optical path that corrects the angle of the laser beam after it enters the optical fiber.

### [Example 4]

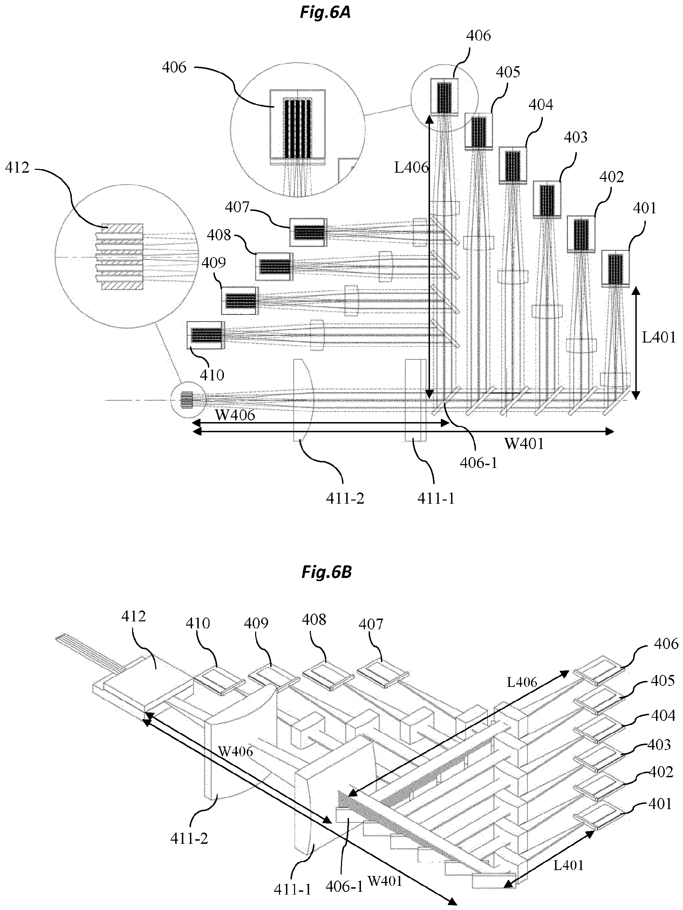

Example 4 a semiconductor laser device that differs from Example 2 in that several modules are stacked in the fast axis direction by multiplexing the reflector of one of the plurality of modules to reduce the device's volume and increase its output power. Figs 6A and 6B show a planar structural view and a three-dimensional structural view, respectively, of a semiconductor laser device in this embodiment.

As shown in Figs. 6Aand 6B, the semiconductor laser device in this example includes ten modules, a FOC including a fast axis focusing cylindrical lens 411-1 and a slow axis focusing cylindrical lens 411-2, and a close-packed structure 412 comprising five optical fibers. Each module comprises one of COSs 401-410, a group of beam shaping components including a FAC and a SAC, and a reflector. Each COS includes five laser light-emitting units that multiplex the FAC and the SAC. The laser beams emitted by the five laser light-emitting units are shaped by the FAC and the SAC, and their direction is changed by the reflector. As a result, the laser beams from the five laser light-emitting units can be coupled into the five optical fibers through the FOC after passing through the FAC, the SAC, and being redirected by the reflector.

The laser beams emitted by the COSs 401-406 in a first portion, which comprises six modules, propagate in a direction that intersects with the propagation direction of the laser beams emitted by the COSs 407-410 in a second portion, which comprises four modules. The reflector corresponding to the COS 406 is multiplexed by the four modules in the second portion. This enables further stacking of the modules, which include the COSs 407, 408, 409, and 410, respectively, in steps along the fast axis direction in the optical path after the SAC and before the reflector corresponding to the COS 406 in the module including the COS 406.

In each of the four modules of the second portion, five laser light-emitting units are used to multiplex one group of FAC and SAC, as well as one reflector. The laser beams respectively emitted by these five laser light-emitting units are collimated in both the fast and slow axis directions through the FAC and the SAC. The direction of the shaped laser beams is then changed by the reflector. Subsequently, the direction of the laser beams is changed once again by the reflector 406-1 that corresponds to the COS 406. This enables the laser beams from the four modules in the second portion to be folded to the same FOC as the laser beams of the six modules in the first portion. As a result, they can be coupled into the five optical fibers.

The optical paths of the laser beams emitted by each COS, including the five laser light-emitting units, to the end faces of the five optical fibers are equal. For instance, the optical path of the beam emitted by the COS 401 is L401 + W401, and the optical path of the beam emitted by the COS 406 is L406 + W406, and L401 + W401 = L406 + W406.

Furthermore, in the plurality of modules, the spacing between adjacent modules in the horizontal (slow axis) direction is the same and greater than "a". In the plurality of modules that are arranged in steps in the vertical direction (fast axis direction), the step height between adjacent modules is also the same and greater than "h".

In other embodiments of the present invention, the COS is not limited to including five laser light-emitting units and may include 2, 3, 4, or more laser light-emitting units. In such cases, the number of corresponding output fibers is equal to the number of laser light-emitting units.

In other embodiments of the present invention, the total number of modules is not limited to 10, the number of modules in the first portion is not limited to 6, and the number of modules in the second portion is not limited to 4. Any desired number of modules may be used, some of which can be arranged as modules in the first portion, and the remaining modules as modules in the second portion.

In some embodiments of the present invention, the device can include more than two portions of modules. For instance, a third or even more portions of modules can be further stacked on the basis of the second portion of modules.

Additionally, in some embodiments of the present invention, the reflectors of more than one module can be multiplexed, for example, the device may further include a third portion of modules that multiplex the reflector of another module in the first portion, and so on.

Moreover, in some embodiments of the present invention, the slow axis collimator lens and the slow axis focusing cylindrical lens can form a double telecentric optical path to correct the angle of the laser beam after it enters the optical fiber.

### [Example 5]

Example 5 provides a semiconductor laser device with a higher integration level and smaller volume compared to Example 2. In this example, a plurality of modules is stacked in parallel in the fast axis direction, reflectors are omitted, and all modules multiplex one SAC.

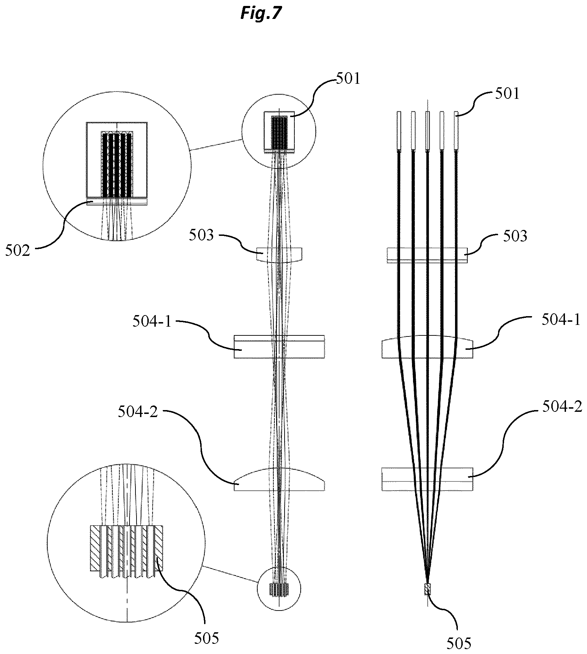

Specifically, as illustrated in Fig. 7, the semiconductor laser device in this example includes five modules, each containing one COS 501 and one FAC 502. The COS 501 comprises five laser light-emitting units that multiplex the FAC 502. The device also includes one SAC 503 and one FOC coupling lens group, consisting of a fast axis focusing cylindrical lens 504-1 and a slow axis focusing cylindrical lens 504-2. The SAC 503 is arranged between the modules and the FOC, allowing the five modules to multiplex the SAC 503 and the FOC 504-1 and 504-2. Additionally, a close-packed structure 505 comprising five optical fibers is included in the device. The laser beams emitted by the five laser light-emitting units of each COS 501 multiplex one FAC. The laser beams from the COS 501 in each module are shaped and focused by the same SAC and FOC in turn, and then respectively coupled into the five optical fibers.

In this example, the optical paths of the laser beams emitted by each COS, including five laser light-emitting units, to the end faces of the five optical fibers are equal.

In some embodiments of the present invention, the COS is not limited to including five laser light-emitting units, and can include 2, 3, 4 or more laser light-emitting units. In such cases, the number of the corresponding output fibers is the same as that of the laser light-emitting units.

In some embodiments of the present invention, the number of modules is not limited to 5, and any number of modules may be provided as needed.

In other embodiments of the present invention, the FOC can also be a single lens, or any other lens that functions as a focusing lens.

In some embodiments of the present invention, the slow axis collimator lens 503 and the slow axis focusing cylindrical lens 504-2 form a double telecentric optical path to correct the angle of the laser beam after it enters the optical fiber.

### [Example 6]

Example 6 provides a semiconductor laser device. In comparison to Example 2, this example includes a spectral beam combiner or a polarization beam combiner arranged between the FOC and the beam shaping components. This allows for further combination of the spectral beam or polarization beam on the basis of spatial beam combination.

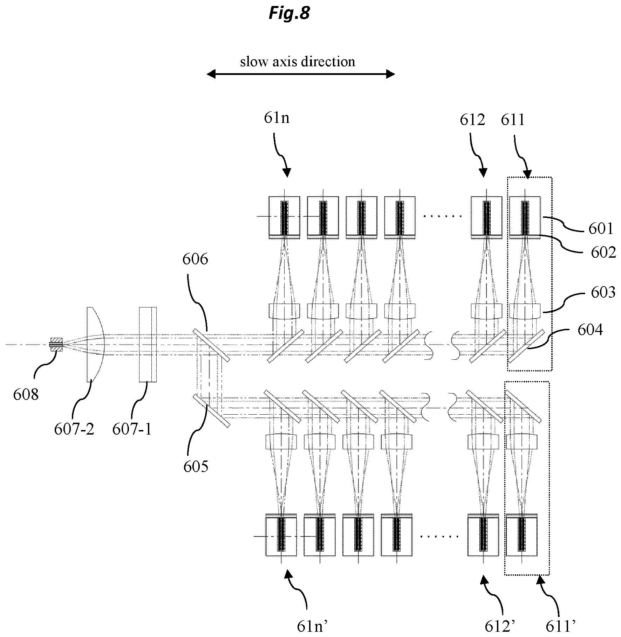

As shown in Fig. 8, the semiconductor laser device in this example comprises a plurality of modules 611, 612, ... 61n and 611', 612', ... 61n', a spectral beam combiner such as a dichroic beam splitter 606, a FOC lens group including a fast axis focusing cylindrical lens 607-1 and a slow axis focusing cylindrical lens 607-2, as well as a close-packed structure 608 including two optical fibers.

In this example, the plurality of modules 611, 612, ... 61n are arranged in steps in the vertical direction (fast axis direction) and in parallel with the same pitch in the horizontal direction (slow axis direction). Each module may include a semiconductor laser chip array COS 601, one group of beam shaping components including a FAC 602 and a SAC 603, and a reflector 604. The COS 601 comprises two laser light-emitting units that multiplex one group of FAC 602 and SAC 603, so that laser beams emitted by the two laser light-emitting units in the slow axis direction pass through the FAC 602 and the SAC 603 respectively, and are shaped by the FAC 602 and the SAC 603. The reflector 604 is multiplexed by the two laser light-emitting units, and the shaped laser beams are folded toward the dichroic beam splitter 606 by the reflector 604. The laser beams emitted by the modules 611, 612, ...61n have a first wavelength.

The structure and layout of the plurality of modules 611', 612', ... 61n' are the same as those of the modules 611, 612, ... 61n. The difference between them is in that the laser beams emitted by the modules 611', 612', ... 61n' have a second wavelength and a reflector 605 is additionally arranged between the modules 611', 612', ... 61n' and the dichroic beam splitter 606 to change the traveling direction of the laser beams to the dichroic beam splitter 606. As the dichroic beam splitter 606, a mirror that transmits the light of the first wavelength and reflects the light of the second wavelength is used.

Since the dichroic beam splitter 606 is capable of transmitting the laser beams with the first wavelength and reflecting the laser beams with the second wavelength, the laser beams from the modules 611, 612, ... 61n with the first wavelength are transmitted through the dichroic beam splitter 606, and the laser beams from the modules 611', 612', ... 61n' with the second wavelength are reflected by the dichroic beam splitter 606 to be stacked and combined with the laser beams from the modules 611, 612, ... 61n. The combined laser beams are then coupled into their corresponding optical fibers through FOC 607-1 and 607-2 respectively. Therefore, the semiconductor laser device in this example can further perform the spectral beam combination on the basis of the spatial beam combination.

In this example, both reflectors 604 and 605 play a role in changing the direction of the laser beams. Depending on the specific requirements, the reflector can be omitted or added to facilitate the combination of laser beams from different spatial positions.

In some embodiments of the present invention, a polarization beam splitter (PBS) can be used in place of the dichroic beam splitter 606 to achieve a combination of the spatial beam combination with the polarization beam combination. In this case, the laser beams emitted by the modules 611, 612, ... 61n may all be *p* light, and the laser beams emitted by the modules 611', 612', ... 61n' may all be s light. The PBS is capable of transmitting *p* light and reflecting s light, allowing the laser beams from the modules 611, 612, ... 61n and the laser beams from modules 611', 612', ... 61n' to be stacked and combined after passing through the PBS, thereby achieving the polarization beam combination.

In an alternative embodiment, a spectral beam combiner and a polarization beam combiner may be provided in order between the FOC and the beam shaping components (specifically, the SAC) to achieve a combination of the spectral beam combination and the polarization beam combination on the basis of spatial beam combination. This entails, for instance, initially overlapping laser beams of different wavelengths through a dichroic beam splitter, as described earlier, followed by superimposing the spectrally combined p light and s light through a PBS, as previously mentioned.

In other embodiments of the present invention, the COS is not limited to including only 2 laser light-emitting units, and may also include 3, 4 or more laser light-emitting units. In such cases, the number of corresponding output fibers is equal to the number of laser light-emitting unit.

In other embodiments of the present invention, the FOC may be a single lens, or any other lens that can function as a focusing lens.

In some embodiments of the present invention, the slow axis collimator lens and the slow axis focusing cylindrical lens may form a double telecentric optical path to correct the angle of the laser beam as it enters the optical fiber.

The terminology and language used in the description of the present invention are provided for illustrative purposes only and should not be construed as limiting the scope of the invention. It is understood by those skilled in the art that various modifications can be made to the specific embodiments described above without deviating from the underlying principles of the disclosed embodiments. Therefore, the scope of the present invention is determined solely by the claims, which should be interpreted in the broadest and most reasonable manner possible, unless otherwise indicated.

## Claims

1. A semiconductor laser device comprising:
at least two laser light-emitting units;
a group of beam shaping components, wherein the at least two laser light-emitting units multiplex the group of beam shaping components to shape the laser beam emitted by each unit;
a fiber optic coupler; and
at least two optical fibers, wherein the laser beams emitted by the at least two laser light-emitting units are respectively coupled into the at least two optical fibers through the fiber optic coupler after being shaped by the group of beam shaping components;
wherein the number of the optical fibers is equal to that of the laser light-emitting units.

2. The semiconductor laser device of claim 1, wherein the laser beams emitted by the at least two laser emitting units have the same propagation direction and the same divergence angle.

3. The semiconductor laser device of claim 2, wherein the at least two laser light-emitting units are produced by cutting a semiconductor laser Bar.

4. The semiconductor laser device of claim 1, wherein the group of beam shaping components comprises a fast axis collimator lens and a slow axis collimator lens.

5. The semiconductor laser device of claim 1, wherein the at least two laser light-emitting units and the group of beam shaping components that are multiplexed by them are used as a module, and the module further comprises a reflector for changing the direction of the laser beams that have been shaped by the group of beam shaping components, and
wherein the semiconductor laser device includes a plurality of said modules.

6. The semiconductor laser device of claim 5, wherein the plurality of modules is configured such that optical paths from the laser light-emitting units of each module to the optical fibers are equal.

7. The semiconductor laser device of claim 5, wherein the spacing between adjacent modules in the plurality of modules in the horizontal direction is the same, and larger than a first value that represents the length of the major axis of the elliptical cross-sectional shape of the laser beam from the reflector.

8. The semiconductor laser device of claim 5, wherein the plurality of modules is arranged in steps in the fast axis direction, with the step height between adjacent modules being the same and larger than a second value that represents the length of the minor axis of the elliptical cross-sectional shape of the laser beam from the reflector.

9. The semiconductor laser device of claim 5, wherein the plurality of modules is configured such that:
the propagation direction of the laser beams emitted from the laser light-emitting units in a first portion of the plurality of modules intersects the propagation direction of the laser beams emitted from the laser light-emitting units in a second portion of the plurality of modules, and
the second portion of the plurality of modules multiplexes the reflector of one module of the first portion.

10. The semiconductor laser device of claim 1, wherein the at least two laser light-emitting units and the group of beam shaping components that are multiplexed by them are used as a module,
wherein the semiconductor laser device includes a plurality of said modules arranged in parallel in a fast axis direction;
wherein the group of beam shaping components comprises a fast axis collimator lens; and
wherein the semiconductor laser device further comprises a slow axis collimator lens arranged between the plurality of modules and the fiber optic coupler, such that the plurality of modules multiplex the slow axis collimator lens.

11. The semiconductor laser device of claim 1, further comprising a corrector provided between the fiber optic coupler and the optical fibers for correcting the angle of each laser beam after it enters the optical fiber.

12. The semiconductor laser device of claim 11, wherein the corrector is a split prism or a concave lens, or the end face of the optical fiber is configured as an inclined end face to function as the corrector.

13. The semiconductor laser device of claim 4 or 10, wherein the fiber optic coupler comprises a slow axis focusing cylindrical lens and a fast axis focusing cylindrical lens.

14. The semiconductor laser device of claim 13, wherein the slow axis collimator lens and the slow axis focusing cylindrical lens form a double telecentric optical path to correct the angle of each laser beam after it enters the optical fiber.

15. The semiconductor laser device of claim 1, wherein the at least two optical fibers are fixed in a close-packed structure or a ceramic ferrule.

16. The semiconductor laser device of claim 1, further comprising a spectral beam combiner and/or a polarization beam combiner between the fiber optic coupler and the group of beam shaping components.
